# EUROPEAN PATENT SPECIFICATION

(11) **EP 3 332 331 B1**
(45) Date of publication and mention of the grant of the patent: **30.12.2020**
(21) Application number: 16833476.1
(22) Date of filing: 05.07.2016
(51) Int. Cl.: G06F 13/16, G06F 3/06, G06F 1/3234

(54) **MEMORY ACCESS CONTROL**
SPEICHERZUGANGSSTEUERUNG
COMMANDE D'ACCÈS À LA MÉMOIRE

(30) Priority: 03.08.2015 US 201514817029
(43) Date of publication of application: 13.06.2018
(60) Divisional application: 20193446.0
(73) Proprietor: Intel Corporation, Santa Clara, CA 95054 (US)
(72) Inventor: HAQUE, Rezaul, Folsom, California 95630 (US); PINILLA PICO, Lady Nataly, Folsom, California 95630 (US)
(74) Representative: Rummler, Felix
(86) International application number: PCT/US2016/040981
(87) International publication number: WO 2017/023470

(56) References cited:
- JP-A- 2003 303 030
- US-A- 6 141 283
- US-A1- 2007 245 036
- US-A1- 2008 046 997
- US-A1- 2008 162 784
- US-A1- 2008 162 784
- US-A1- 2011 191 548
- US-B2- 6 701 457

## Description

### FIELD

The present disclosure relates to memory access control.

### BACKGROUND

Unwanted memory commands have the ability to corrupt data, which may cause failures at the application and system level. Protection of data in a memory array has been proposed using various complex schemes which increase the cost and complexity of the system. At a system level, maintaining voltage sequences are costly when a system shutdown happens because power management is needed to manage these situations. But, without power management, there is always the potential that array data within memory component may be corrupted, for example, during an unsequenced power shutdown.

US 2008/162784 A1 discloses a memory device, that can be accessed from a host processor, comprising a security processor and a memory module. The memory module can be partitioned by using a partitioning component of security processor. The security processor can differentiate between legitimate and illegitimate memory access commands. Furthermore, depending upon the level of access rights granted to a host processor, a partition of the memory module can be closed or open.

### BRIEF DESCRIPTION OF DRAWINGS

Features and advantages of the claimed subject matter will be apparent from the following detailed description of embodiments consistent therewith, which description should be considered with reference to the accompanying drawings, wherein:
FIG. 1 illustrates a system block diagram, consistent with several embodiments of the present disclosure;
FIG. 2 illustrates a flowchart of operations of memory controller circuitry consistent with one embodiment of the present disclosure;
FIG. 3 illustrates a flowchart of operations of memory controller circuitry consistent with another embodiment of the present disclosure; and
FIG. 4 illustrates a flowchart of operations of partition control circuitry consistent with one embodiment of the present disclosure.

Although the following Detailed Description will proceed with reference being made to illustrative embodiments, many alternatives, modifications, and variations thereof will be apparent to those skilled in the art.

### DETAILED DESCRIPTION

Generally, this disclosure describes a system and method for data protection in a memory array. In some embodiments, the memory array is segmented into a plurality of partitions. At least one partition control circuit is provided that controls memory access and/or power management for at least one partition. The at least one partition control circuit is configured to generate an active/idle state signal indicative of whether the partition control circuitry is in an idle/low-power state or in an operational (memory access) state. Memory controller circuitry is configured to receive the state signal from the partition control circuitry and control a clock signal to the partition control circuitry. The memory controller circuitry is also configured to receive a memory access command that may be legitimate or illegitimate. A legitimate command may include, for example, memory read/write commands, force read command, reset only write command,, etc. Illegitimate commands include unwanted and/or spurious commands that may corrupt data in the array, and may include, for example, voltage coupling, power sequence operations, etc. If the command is legitimate, the memory controller may enable the clock signal for the partition control circuit to enable the partition control circuit to decode and process the legitimate command. While processing the legitimate command, the partition control circuit may change the state of the state signal to indicate an active state, and once completed, may change the state signal to indicate an idle state, so that the memory controller circuitry can decouple, or gate, the clock signal from the partition control circuit. Advantageously, this may enable the array partition to enter an idle and/or low power state while being protected from illegitimate commands.

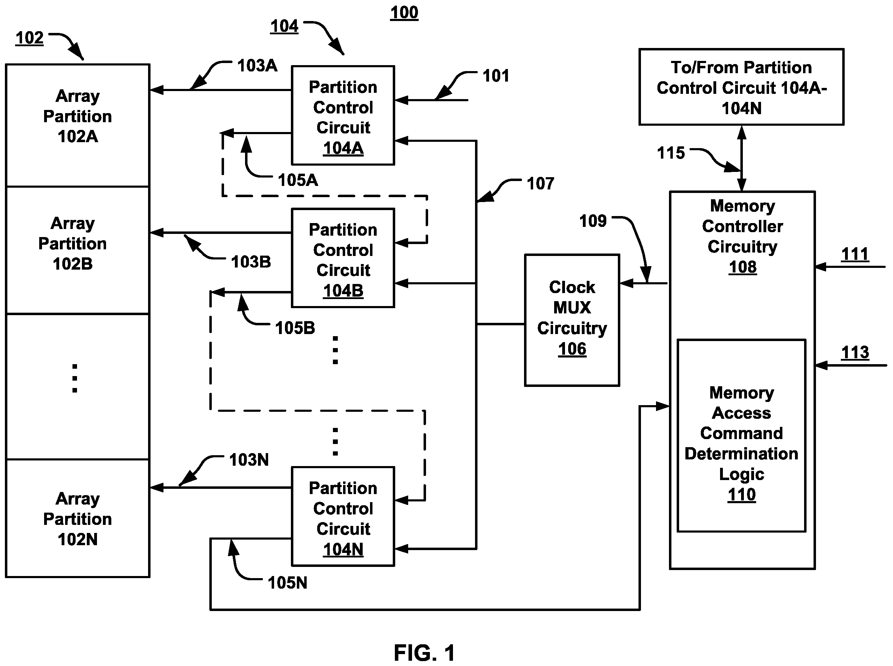

FIG. 1 illustrates a system block diagram 100 consistent with several embodiments of the present disclosure. The system 100 includes a memory array 102, partition control circuitry 104 that includes a plurality of partition control circuits 104A, 104B,...,104N, clock multiplexing (MUX) circuitry 106 and memory controller circuitry 108. In the embodiments described herein, the memory array 102 may be segmented (logically and/or physically) into a plurality of partitions (e.g., plurality of "panels" or "tiles", etc.) 102A, 102B,..., 102N. The size of each memory partition 102A, 102B,..., 102N may be based on, for example, the size of the overall array 102, memory addresses, physical location of memory structures, etc. Memory array 102 may include non-volatile memory structures (e.g., phase change or crosspoint memory, etc.) and/or volatile memory such as random access memory, cache memory, etc. In some embodiments, partition control circuits 104A, 104B,...,104N are provided to control (e.g., read/write access control, power management control, etc.) of a respective partition 102A, 102B,..., 102N of the memory array 102. In other embodiments, a partition control circuit, e.g., partition control circuitry 104A may control more than one memory partition, e.g., partitions 102A and 102B, and thus there may be less than N number of individual partition control circuits. Memory controller circuitry 108 is generally configured to receive a memory access command 113 and control application of a clock signal 109 to at least one partition control circuit 104A, 104B,...,104N, as will be described below. The memory access command 113 may be generated by, for example, a central processing unit (e.g., system CPU, not shown) and/or subset thereof (e.g., one or more cores of a system CPU, etc., not shown) executing one or more applications (also not shown) which require access to memory array 102.

In one embodiment, partition control circuit 104A, 104B,...,104N are each configured to generate and propagate an active/idle signal 105A, 105B,...,105N. The active/idle signal 105A, 105B,...,105N is indicative of the state of at least one partition control circuit 104A, 104B,...,104N. The "state", as used herein, means either an active state in which at least one partition control circuit 104A, 104B,..., and/or104N is decoding and/or processing a legitimate memory access command, or an idle/low-power state in which the partition control circuit 104A, 104B,..., and/or104N is gated from memory controller circuitry 108. In one embodiment, the first partition control circuit 104A is configured to receive an idle signal 101 and propagate the idle signal as the active/idle signal 105A if the partition control circuit 104A is not processing a memory access command. The idle signal 101 may include, for example, an available reference voltage (e.g., Vcc, etc.). If any of the partition control circuits 104A, 104B,..., and/or 104N is in an active state, that partition control circuit is configured to change the state of the active/idle signal 105A, 105B,..., and/or 105N to indicate an active state. The last partition control circuit 104N is configured to transmit the active/idle signal 105N to the memory controller circuitry 108. Since any of the partition control circuits 104A, 104B,..., and/or 104N can change the state of a respective active/idle signal 105A, 105B,..., and/or 105N, the last active/idle signal 105N is indicative of all partition control circuits 104A, 104B,..., and 104N being in an idle/low-power state, or at least one partition control circuit 104A, 104B,..., and/or104N being in an active state. In another embodiment, instead of propagating a respective active/idle signal 105A, 105B,..., 105N through each partition control circuitry 104A, 104B,...,104N , each active/idle signal 105A, 105B,..., 105N may be transmitted directly to memory controller circuitry 108, at the possible expense of additional pinout requirements and/or bus and bus control requirements.

The memory controller circuitry 108 is generally configured to gate the application of clock signal 109 to at least one partition control circuit 104A, 104B,..., and/or 104N based on, at least in part, the type of memory access command 113 received by the memory controller circuitry 108. As described above, a memory access command 113 may generally be legitimate or illegitimate. Accordingly, memory controller circuitry 108 may also include memory access command determination logic 110 generally configured to determine if a memory access command 113 is legitimate or illegitimate. To that end, memory access command determination logic 110 may be configured to parse an incoming memory access command to determine certain features of the command that trend to demonstrate that the memory access command 113 is legitimate or illegitimate. Features that may demonstrate that the memory access command 113 is legitimate include, for example, command decode information,
proper clock signaling, etc. while features that may demonstrate that the memory access command 113 is illegitimate include, for example, voltage coupling, power sequence operations, etc.. Memory controller circuitry 108 may remain in a low power/idle state in the absence of a memory access command 113.

If a memory access command 113 is determined to be legitimate, memory controller circuitry 108 is configured to turn on a clock signal 109 to enable at least one partition control circuit 104A, 104B,..., and/or 104N to decode and/or process the memory access command 113. The clock signal 109 may include a clock signal 111 received from a system clock generator (not shown), etc., and may further include a clock signal 111 from a different clock domain. The clock MUX circuitry 106 is generally configured to receive a clock signal 109 and route a similar clock signal 107 to at least one partition control circuit 104A, 104B,..., and/or 104N, depending on, for example, address information identified in the memory access command 113. In some embodiments, clock MUX circuitry 106 is configured to route the clock signal 107 only to the partition control circuit 104A, 104B,..., and/or 104N that will be processing (or is processing) the memory access command 113. Once the clock signal 107 is applied to one or more of the partition control circuitry 104A, 104B,..., and/or 104N, memory controller may transmit a wake up signal, via bus 115, to the place the appropriate partition control circuitry 104A, 104B,..., and/or 104N in a condition to receive and process (decode) the memory access command 113. Once the appropriate partition control circuit 104A, 104B,..., and/or 104N is in a state that is ready to process (which may be verified by a wake-up handshake signal, etc.), the memory access command 113 may be transmitted to the appropriate partition control circuit 104A, 104B,..., and/or 104N for decoding/processing, via bus 115. Data associated with the memory access command 113 and any data results from the memory access command (e.g., read results) may be transmitted between the memory controller circuitry 108 and the appropriate partition control circuit 104A, 104B,..., and/or 104N, via bus 115.

As described above, if at least one partition control circuit 104A, 104B,..., and/or 104N is processing a memory access command 113, the state of the active/idle signal 105A, 105B,..., and/or 105N may indicate an active state. Accordingly, memory controller circuitry 108 is configured to enable the clock signal 109 for as long as the active/idle signal 105A, 105B,..., and/or 105N indicates an active state. Once any or all of the circuits 104A, 104B,..., and/or 104N has completed processing of a memory access command 113, and the corresponding the active/idle signal 105A, 105B,..., and/or 105N changes state from active to idle, memory controller circuitry 108 is configured to disable (e.g., gate) the clock signal 109 (and correspondingly, clock signal 107) to the appropriate circuitry 104A, 104B,..., and/or 104N. More than one legitimate memory access command 113 for a particular partition 102A, 102B,..., and/or 102N may be received by memory controller circuitry 108. In such a case, memory controller circuitry 108 may be configured to queue the memory access commands 113 and maintain the clock signal until all such commands have been executed. This may reduce lag time associated with waking up of partition control circuit 104A, 104B,..., and/or 104N between memory access commands 113. If memory access command determination logic 110 determines that a memory access command 113 is illegitimate, the memory controller circuitry may keep the clock signal 109 disabled for all or any of the partition control circuits 104A, 104B,..., and/or 104N. In some embodiments, memory controller circuitry 108 may be configured to generate a signal that indicates that the received memory access command 113 is illegitimate. Thus, partition control circuitry 104A, 104B,..., and/or 104N and/or corresponding partitions 102A, 102B,..., and/or 102N may enter a low power state and may be protected from spurious and/or unwanted (illegitimate) memory access commands.

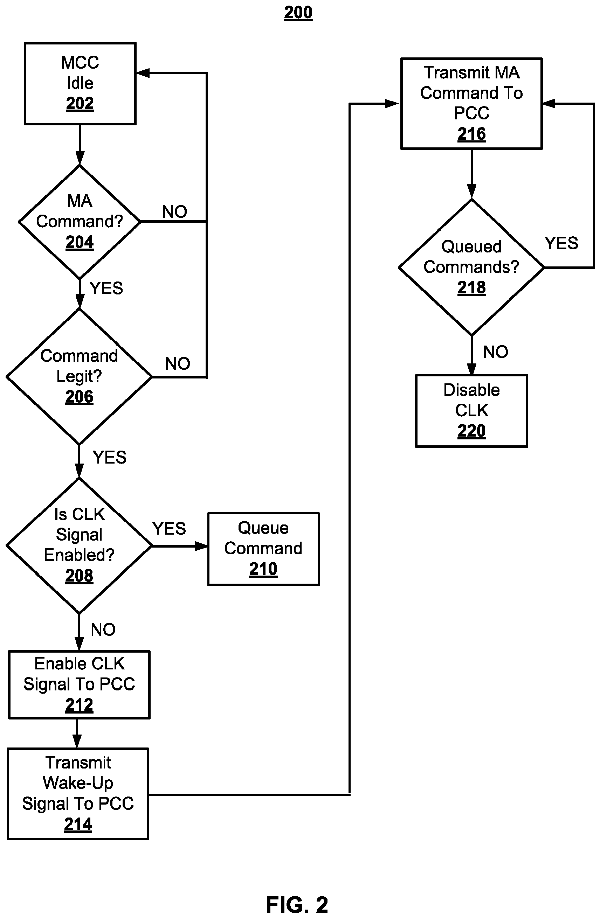

FIG. 2 illustrates a flowchart 200 of operations of memory controller circuitry consistent with one embodiment of the present disclosure. The operations may be performed, for example, by memory controller circuitry 108 (FIG. 1) and/or other memory controller circuitry. Operations of this embodiment include maintaining memory controller circuitry (MCC) in an idle state 202, and determining if a memory access (MA) command is received 204. If no MA is received 204, operations may include maintaining the MCC in an idle state 202. If a MA command is received (204), operations may also include determining if the MA command is legitimate 206. If the MA command is not legitimate (illegitimate) (206), operations may include operations may include maintaining the MCC in an idle state 202. If the MA command is legitimate (206), operations may include determining if a clock (CLK) signal is enabled 208, and if so (indicating that a current MA command is being executed), queuing the MA command 208 to be performed after the current command operations are complete. If the CLK signal is not enabled (208), operations may include enabling the CLK signal to at least one partition control circuit (PCC) 212. Operations may also include transmitting a wake-up signal to the at least one PCC 214. The wake-up signal may be a handshake and/or other signal type to enable the PCC to transition from a low-power and/or idle state to an active state. Operations may also include transmitting the MA command to the PCC 216. Operations may also include determining if there are any queued MA commands 218, and if so, transmitting the queued commands to the PCC 216, thus avoiding unnecessary clock cycling and/or wake-up transitions. Once the MA command is completed by the at least one PCC (and once any results have been transmitted to the MCC), operations may also include disabling the CLK signal 220, to permit, for example, the PCC to transition to a low-power state and to gate illegitimate memory access commands.

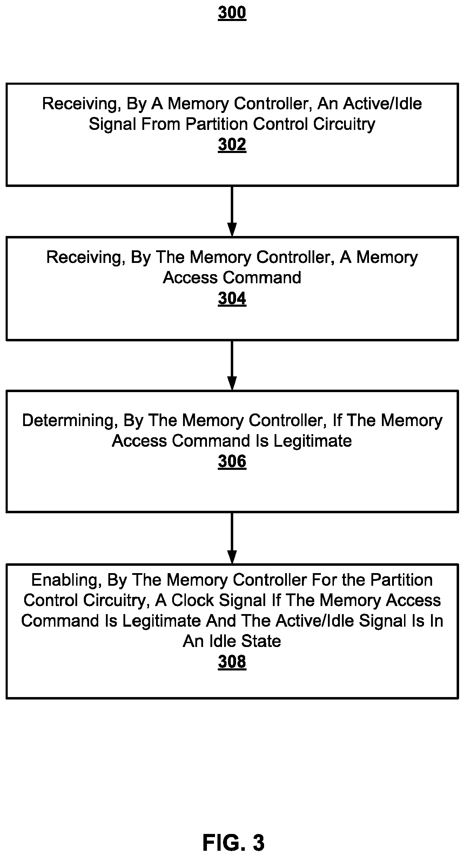

FIG. 3 illustrates a flowchart 300 of operations of memory controller circuitry consistent with another embodiment of the present disclosure. The operations may be performed, for example, by memory controller circuitry 108 (FIG. 1) and/or other memory controller circuitry. Operations of this embodiment include receiving, by a memory controller, an active/idle signal from a partition control circuit 302. The partition control circuit controls at least one partition of a memory array, and the active/idle signal has a state indicative of one of an active state or an idle state of the partition control circuit. Operations may also include receiving, by the memory controller, a memory access command 304. Operations may also include determining, by the memory controller, if the memory access command is legitimate 306. Operations may also include enabling, by the memory controller for the partition control circuit, a clock signal if the memory access command is legitimate and the active/idle signal is in an idle state 308.

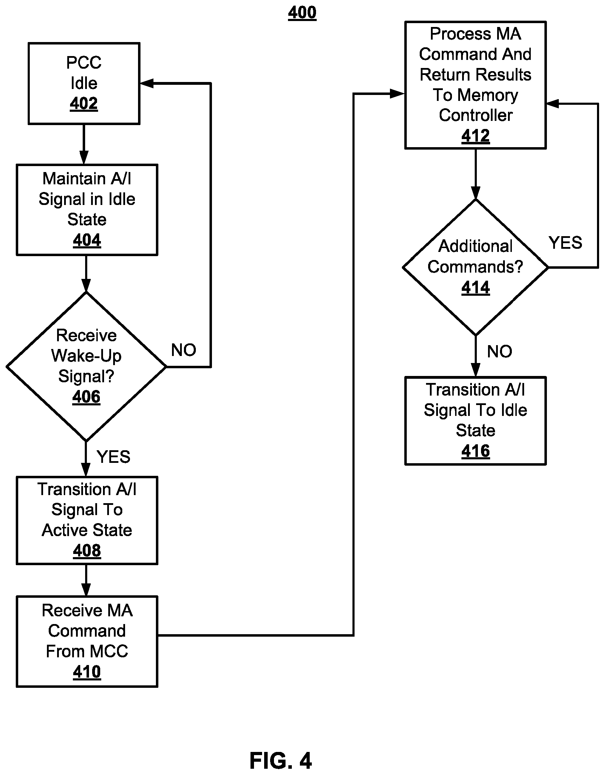

FIG. 4 illustrates a flowchart 400 of operations of partition control circuitry consistent with one embodiment of the present disclosure. The operations may be performed, for example, by partition control circuit, e.g., circuit 104A (FIG. 1) and/or other circuitry associated with a partition of a memory array. Operations of this embodiment include maintaining the partition control circuit (PCC) in an idle and/or low-power state 402. Operations may also include maintaining an active/idle (A/I) signal in an idle state 404. Operations may also include determining, by the PCC, if a wake-up signal has been received 406. The wake-up signal may be generated by, for example, a memory controller to enable the PCC to transition from an idle state to an active state. If no wake-up signal is received (406) the PCC may remain in an idle state 402. If a wake-up signal is received (406), operations may include transitioning the A/I signal to an active state 408 and receiving a memory access (MA) command 410 from, for example, the memory controller. Operations may also include processing the MA command and returning any results to the memory controller 412. Operations may also include determining if there are any additional MA commands 414, and if so processing those commands 412. Once all commands have been processed, operations may also include transitioning the A/I signal to an idle state 416.

While FIGS. 2-4 illustrate various operations according various embodiments, it is to be understood that not all of the operations depicted in FIG. 2, 3 or 4 are necessary for other embodiments. Indeed, it is fully contemplated herein that in other embodiments of the present disclosure, the operations depicted in FIG. 2, 3 and/or 4, and/or other operations described herein may be combined in a manner not specifically shown in any of the drawings, but still fully consistent with the present disclosure. Thus, claims directed to features and/or operations that are not exactly shown in one drawing are deemed within the scope and content of the present disclosure.

As used in any embodiment herein, the term "logic" may refer to an application, software, firmware and/or circuitry configured to perform any of the aforementioned operations. Software may be embodied as a software package, code, instructions, instruction sets and/or data recorded on non-transitory computer readable storage device. Firmware may be embodied as code, instructions or instruction sets and/or data that are hard-coded (e.g., nonvolatile) in memory devices. "Circuitry" and "circuitry", as used in any embodiment herein, may comprise, for example, singly or in any combination, hardwired circuitry, programmable circuitry such as computer processors comprising one or more individual instruction processing cores, state machine circuitry, and/or firmware that stores instructions executed by programmable circuitry. The circuitry may include a processor and/or controller configured to execute one or more instructions to perform one or more operations described herein. The instructions may be embodied as, for example, an application, software, firmware, etc. configured to cause the circuitry to perform any of the aforementioned operations. Software may be embodied as a software package, code, instructions, instruction sets and/or data recorded on a computer-readable storage device. Firmware may be embodied as code, instructions or instruction sets and/or data that are hard-coded (e.g., nonvolatile) in memory devices. The circuitry may, collectively or individually, be embodied as circuitry that forms part of a larger system, for example, an integrated circuit (IC), an application-specific integrated circuit (ASIC), a system on-chip (SoC), desktop computers, laptop computers, tablet computers, servers, smart phones, etc.

Any of the operations described herein may be implemented in a system that includes one or more storage devices having stored thereon, individually or in combination, instructions that when executed by one or more processors perform one or more operations. Also, it is intended that operations described herein may be distributed across a plurality of physical devices, such as processing structures at more than one different physical location. The storage devices may include any type of tangible device, for example, any type of disk including hard disks, floppy disks, optical disks, compact disk read-only memories (CD-ROMs), compact disk rewritables (CD-RWs), and magneto-optical disks, semiconductor devices such as read-only memories (ROMs), random access memories (RAMs) such as dynamic and static RAMs, erasable programmable read-only memories (EPROMs), electrically erasable programmable read-only memories (EEPROMs), flash memories, Solid State Disks (SSDs), magnetic or optical cards, or any type of media suitable for storing electronic instructions. Other embodiments may be implemented as software executed by a programmable control device. As described herein, various embodiments may be implemented using hardware elements, software elements, or any combination thereof. Examples of hardware elements may include processors, microprocessors, circuits, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), logic gates, registers, semiconductor device, chips, microchips, chip sets, and so forth.

Reference throughout this specification to "one embodiment" or "an embodiment" means that a particular feature, structure, or characteristic described in connection with the embodiment is included in at least one embodiment. Thus, appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

In some embodiments, a hardware description language may be used to specify circuit and/or logic implementation(s) for the various modules and/or circuitry described herein. For example, in one embodiment the hardware description language may comply or be compatible with a very high speed integrated circuits (VHSIC) hardware description language (VHDL) that may enable semiconductor fabrication of one or more circuits and/or modules described herein. The VHDL may comply or be compatible with IEEE Standard 1076-1987, IEEE Standard 1076.2, IEEE1076.1, IEEE Draft 3.0 of VHDL-2006, IEEE Draft 4.0 of VHDL-2008 and/or other versions of the IEEE VHDL standards and/or other hardware description standards.

Various features, aspects, and embodiments have been described herein. The features, aspects, and embodiments are susceptible to combination with one another as well as to variation and modification, as will be understood by those having skill in the art. The present disclosure should, therefore, be considered to encompass such combinations, variations, and modifications.

## Claims

1. An apparatus comprising:
partition control circuitry configured to control at least one partition of a memory array, the partition control circuitry also configured to receive a controlled clock signal to enable execution of a legitimate memory access command and to generate an active/idle signal having an active state during execution of the legitimate memory access command or having an idle state in response to completion of execution of the legitimate memory access command.

2. The apparatus of claim 1, wherein the legitimate memory access command includes at least one of a read command, a write command, a force write command and a reset only write command.

3. The apparatus of claim 1, wherein the partition control circuitry is also configured to receive a wake-up command to transition the partition control circuitry from an idle state to an active state.

4. The apparatus of any of claims 1-3, wherein the partition control circuitry includes a plurality of partition control circuits each configured to control a respective partition of the memory array, and wherein each partition control circuit is configured to generate a respective active/idle signal.

5. The apparatus of claim 4, wherein each partition control circuit is configured to propagate a respective active/idle signal from a previous partition control circuit to a subsequent partition control circuit, and wherein a last partition control circuit is configured to transmit the active/idle signal indicative of an active or idle state of at least one partition control circuit.

6. A method comprising:
receiving, by a memory controller, an active/idle signal from partition control circuitry; wherein the partition control circuitry is configured to control at least one partition of a memory array and wherein the active/idle signal has a state indicative of one of an active state or an idle state of the partition control circuitry;
receiving, by the memory controller, a memory access command;
determining, by the memory controller, if the memory access command is legitimate; and
enabling, by the memory controller, a clock signal for the partition control circuitry if the memory access command is legitimate and if the active/idle signal is in an idle state.

7. The method of claim 6, wherein the determining, by the memory controller, if the memory access command is legitimate includes parsing the memory access command to discover if the memory access command includes at least one of a read command, a write command, a force write command and a reset only write command.

8. The method of claim 6, further comprising determining, by the memory controller, if the memory access command is illegitimate by parsing the memory access command to determine if the memory access command includes a voltage coupling or a power sequence operation.

9. The method of claim 6, further comprising:
determining, by the memory controller, if the clock signal is enabled from a previous memory access command; and
queuing the memory access command if the clock signal is enabled.

10. The method of claim 6, further comprising transmitting a wake-up signal to the partition control circuitry to enable the partition control circuitry to transition from an idle state to an active state.

11. A computer readable storage device having stored thereon instructions that when executed by one or more processors result in the following operations including the method according to any one of claims 6 to 10.

12. A system comprising:
the apparatus of claim 1 and memory controller circuitry configured to receive a memory access command and determine if the memory access command is legitimate or illegitimate, and configured to enable a clock signal if the memory access command is legitimate;
wherein the memory controller circuitry is configured to disable the clock signal to the at least one partition control circuitry when the active/idle signal is in an idle state.

13. The system of claim 12, wherein the memory controller circuitry is also configured to parse the memory access command to discover if the memory access command includes at least one of a read command, a write command, a force write command and a reset only write command.

14. The system of claim 12, wherein the memory controller circuitry is also configured to parse the memory access command to determine if the memory access command includes a voltage coupling or a power sequence operation.

15. The system of claim 12, wherein the memory controller is also configured to determine if the clock signal is enabled from a previous memory access command; and is configured to queue the memory access command if the clock signal is enabled.

## Patentansprüche

1. Vorrichtung, die Folgendes umfasst:
eine Partitionssteuerschaltung, die konfiguriert ist, mindestens eine Partition einer Speicheranordnung zu steuern, wobei die Partitionssteuerschaltung außerdem konfiguriert ist, ein gesteuertes Taktsignal zu empfangen, um die Ausführung eines legitimen Speicherzugriffsbefehls zu ermöglichen, und ein Aktiv-/Ruhesignal mit einem aktiven Zustand während der Ausführung des legitimen Speicherzugriffsbefehls oder mit einem Ruhezustand als Reaktion auf den Abschluss der Ausführung des legitimen Speicherzugriffsbefehls zu erzeugen.

2. Vorrichtung nach Anspruch 1, wobei der legitime Speicherzugriffsbefehl einen Lesebefehl und/oder einen Schreibbefehl und/oder einen Zwangsschreibbefehl und/oder einen Nur-Rückstell-Schreibbefehl enthält.

3. Vorrichtung nach Anspruch 1, wobei die Partitionssteuerschaltung außerdem konfiguriert ist, einen Aufweckbefehl zu empfangen, um die Partitionssteuerschalung von einem Ruhezustand in einen aktiven Zustand zu überführen.

4. Vorrichtung nach einem der Ansprüche 1-3, wobei die Partitionssteuerschaltung mehrere Partitionssteuerschaltungen enthält, die jeweils konfiguriert sind, eine jeweilige Partition der Speicheranordnung zu steuern, und wobei jede Partitionssteuerschaltung konfiguriert ist, ein jeweiliges Aktiv-/Ruhesignal zu erzeugen.

5. Vorrichtung nach Anspruch 4, wobei jede Partitionssteuerschaltung konfiguriert ist, ein jeweiliges Aktiv-/Ruhesignal von einer vorherigen Partitionssteuerschaltung zu einer folgenden Partitionssteuerschaltung zu verbreiten und wobei eine letzte Partitionssteuerschaltung konfiguriert ist, das Aktiv-/Ruhesignal, das einen aktiven Zustand oder einen Ruhezustand mindestens einer Partitionssteuerschaltung angibt, zu senden.

6. Verfahren, das Folgendes umfasst:
Empfangen durch eine Speichersteuereinheit eines Aktiv-/Ruhesignals von einer Partitionssteuerschaltung; wobei die Partitionssteuerschaltung konfiguriert ist, mindestens eine Partition einer Speicheranordnung zu steuern und wobei das Aktiv-/Ruhesignal einen Zustand besitzt, der einen aktiven Zustand oder einen Ruhezustand der Partitionssteuerschaltung angibt;
Empfangen durch die Speichersteuereinheit eines Speicherzugriffsbefehls;
Bestimmen durch die Speichersteuereinheit, ob der Speicherzugriffsbefehl legitim ist; und
Aktivieren durch die Speichersteuereinheit eines Taktsignals für die Partitionssteuerschaltung, wenn der Speicherzugriffsbefehl legitim ist und wenn das Aktiv-/Ruhesignal in einem Ruhezustand ist.

7. Verfahren nach Anspruch 6, wobei das Bestimmen durch die Speichersteuereinheit, ob der Speicherzugriffsbefehl legitim ist, enthält, den Speicherzugriffsbefehl zu parsen, um festzustellen, ob der Speicherzugriffsbefehl einen Lesebefehl und/oder einen Schreibbefehl und/oder einen Zwangsschreibbefehl und/oder einen Nur-Rückstell-Schreibbefehl enthält.

8. Verfahren nach Anspruch 6, das ferner umfasst, durch die Speichersteuereinheit durch Parsen des Speicherzugriffsbefehls, um zu bestimmen, ob der Speicherzugriffsbefehl einen Spannungskopplungs- oder einen Leistungsfolgevorgang enthält, zu bestimmen, ob der Speicherzugriffsbefehl legitim ist.

9. Verfahren nach Anspruch 6, das ferner Folgendes umfasst:
Bestimmen durch die Speichersteuereinheit, ob das Taktsignal von einem vorherigen Speicherzugriffsbefehl aktiviert worden ist; und
Einreihen in die Warteschlange des Speicherzugriffsbefehls, wenn das Taktsignal aktiviert ist.

10. Verfahren nach Anspruch 6, das ferner umfasst, ein Aufwecksignal an die Partitionssteuerschaltung zu senden, um der Partitionssteuerschaltung zu ermöglichen, von einem Ruhezustand in einen aktiven Zustand überzugehen.

11. Computerlesbare Speichervorrichtung mit auf ihr gespeicherten Anweisungen, die dann, wenn sie durch einen oder mehrere Prozessoren ausgeführt werden, die folgenden Vorgänge ergeben, die das Verfahren nach einem der Ansprüche 6 bis 10 enthalten.

12. System, das Folgendes umfasst:
die Vorrichtung nach Anspruch 1 und eine Speichersteuereinheitsschaltung, die konfiguriert ist, einen Speicherzugriffsbefehl zu empfangen und zu bestimmen, ob der Speicherzugriffsbefehl legitim oder nicht legitim ist, und konfiguriert ist, ein Taktsignal zu aktivieren, wenn der Speicherzugriffsbefehl legitim ist;
wobei die Speichereinheitsschaltung konfiguriert ist, das Taktsignal für die mindestens eine Partitionssteuerschaltung zu deaktivieren, wenn das Aktiv-/Ruhesignal in einem Ruhezustand ist.

13. System nach Anspruch 12, wobei die Speichersteuereinheitsschaltung außerdem konfiguriert ist, den Speicherzugriffsbefehl zu parsen, um festzustellen, ob der Speicherzugriffsbefehl einen Lesebefehl und/oder einen Schreibbefehl und/oder einen Zwangsschreibbefehl und/oder einen Nur-Rückstell-Schreib-Befehl enthält.

14. System nach Anspruch 12, wobei die Speichereinheitsschaltung außerdem konfiguriert ist, den Speicherzugriffsbefehl zu parsen, um zu bestimmen, ob der Speicherzugriffsbefehl einen Spannungskopplungs- oder einen Leistungsfolgevorgang enthält.

15. System nach Anspruch 12, wobei die Speichersteuereinheit außerdem konfiguriert ist, zu bestimmen, ob das Taktsignal von einem vorherigen Speicherzugriffsbefehl aktiviert ist; und konfiguriert ist, den Speicherzugriffsbefehl in eine Warteschlange einzureihen, wenn das Taktsignal aktiviert ist.

## Revendications

1. Appareil comprenant :
des circuits de commande de partition configurés pour commander au moins une partition d'une matrice de mémoire, les circuits de commande de partition étant également configurés pour recevoir un signal d'horloge commandé afin de permettre l'exécution d'une commande d'accès à la mémoire légitime et générer un signal actif/inactif ayant un état actif durant l'exécution de la commande d'accès à la mémoire légitime ou ayant un état inactif en réponse à l'achèvement de l'exécution de la commande d'accès à la mémoire légitime.

2. Appareil selon la revendication l, dans lequel la commande d'accès à la mémoire légitime comporte au moins une commande de lecture, une commande d'écriture, une commande d'écriture forcée et/ou une commande d'écriture de réinitialisation uniquement.

3. Appareil selon la revendication l, dans lequel les circuits de commande de partition sont aussi configurés pour recevoir une commande de réveil afin de faire passer les circuits de commande de partition d'un état inactif à un état actif.

4. Appareil selon l'une quelconque des revendications 1 à 3, dans lequel les circuits de commande de partition comportent une pluralité de circuits de commande de partition configurés chacun pour commander une partition respective de la matrice de mémoire, et dans lequel chaque circuit de commande de partition est configuré pour générer un signal actif/inactif respectif.

5. Appareil selon la revendication 4, dans lequel chaque circuit de commande de partition est configuré pour propager un signal actif/inactif respectif d'un circuit de commande partition précédent à un circuit de commande de partition suivant, et dans lequel un dernier circuit de commande de partition est configuré pour transmettre le signal actif/inactif indiquant un état actif ou inactif d'au moins un circuit de commande de partition.

6. Procédé comprenant :
la réception, par un contrôleur de mémoire, d'un signal actif/inactif à partir de circuits de commande partition ; les circuits de commande de partition étant configurés pour commander au moins une partition d'une matrice de mémoire et le signal actif/inactif ayant un état indiquant un état actif ou un état inactif des circuits de commande de partition ;
la réception, par le contrôleur de mémoire, d'une commande d'accès à la mémoire ;
la détermination, par le contrôleur de mémoire, que la commande d'accès à la mémoire est légitime ou non ; et
l'activation, par le contrôleur de mémoire, d'un signal d'horloge pour les circuits de commande de partition si la commande d'accès à la mémoire est légitime et si le signal actif/inactif est dans un état inactif.

7. Procédé selon la revendication 6, dans lequel la détermination, par le contrôleur de mémoire, que la commande d'accès à la mémoire est légitime ou non comporte l'analyse syntaxique de la commande d'accès à la mémoire pour découvrir que la commande d'accès à la mémoire comporte au moins une commande de lecture, une commande d'écriture, une commande d'écriture forcée et/ou une commande d'écriture de réinitialisation uniquement.

8. Procédé selon la revendication 6, comprenant en outre la détermination, par le contrôleur de mémoire, que la commande d'accès à la mémoire est illégitime ou non en analysant syntaxiquement la commande d'accès à la mémoire pour déterminer que la commande d'accès à la mémoire comporte ou non une opération de couplage de tension ou de séquence de puissance.

9. Procédé selon la revendication 6, comprenant en outre :
la détermination, par le contrôleur de mémoire, que le signal d'horloge est activé ou non à partir d'une commande d'accès à la mémoire précédente ; et
la mise en file d'attente de la commande d'accès à la mémoire si le signal d'horloge est activé.

10. Procédé selon la revendication 6, comprenant en outre la transmission d'un signal de réveil aux circuits de commande de partition pour permettre aux circuits de commande de partition de passer d'un état inactif à un état actif.

11. Dispositif de mémorisation lisible par ordinateur sur lequel sont mémorisées des instructions qui, à leur exécution par un ou plusieurs processeurs, entraînent les opérations suivantes dont le procédé selon l'une quelconque des revendications 6 à 10.

12. Système comprenant :
l'appareil selon la revendication 1 et
des circuits de contrôleur de mémoire configurés pour recevoir une commande d'accès à la mémoire et déterminer que la commande d'accès à la mémoire est légitime ou illégitime, et configurés pour activer un signal d'horloge si la commande d'accès à la mémoire est légitime ;
dans lequel les circuits de contrôleur de mémoire sont configurés pour désactiver le signal d'horloge allant à l'au moins un circuit de commande de partition quand le signal actif/inactif est dans un état inactif.

13. Système selon la revendication 12, dans lequel les circuits de contrôleur de mémoire sont aussi configurés pour analyser syntaxiquement la commande d'accès à la mémoire pour découvrir que la commande d'accès à la mémoire comporte ou non au moins une commande de lecture, une commande d'écriture, une commande d'écriture forcée et/ou une commande d'écriture de réinitialisation uniquement.

14. Système selon la revendication 12, dans lequel les circuits de contrôleur de mémoire sont aussi configurés pour analyser syntaxiquement la commande d'accès à la mémoire pour déterminer que la commande d'accès à la mémoire comporte ou non une opération de couplage de tension ou de séquence de puissance.

15. Système selon la revendication 12, dans lequel le contrôleur de mémoire est aussi configuré pour déterminer que le signal d'horloge est activé ou non à partir d'une commande d'accès à la mémoire précédente ; et est configuré pour mettre en file d'attente la commande d'accès à la mémoire si le signal d'horloge est activé.
